# EUROPEAN PATENT APPLICATION

(11) **EP 1 150 086 A1**
(43) Date of publication of application: **31.10.2001**
(21) Application number: 00303517.7
(22) Date of filing: 26.04.2000
(51) Int. Cl.: F28D 15/02, H01L 23/427

(54) **Flexible volume-variable heat-conducting device**

(71) Applicant: Ko, Yaw-Lin, Ling-Ya Dist., Kaohsiung City (TW)
(72) Inventor: Ko, Yaw-Lin, Ling-Ya Dist., Kaohsiung City (TW)
(74) Representative: Gordon, Michael Vincent

(57) **Abstract**

A flexible volume-variable heat-conducting device (3) is adapted for conducting heat generated by a heat-producing component (15) to a heat-dissipating unit (14), and includes flexible upper and lower thin film layers (32, 33), and an amount of working liquid (30). The upper and lower thin film layers (32, 33) have peripheral portions (321, 331) that are connected sealingly to each other such that the upper and lower thin film layers (32, 33) cooperatively confine a receiving space (35) therebetween. The upper and lower thin film layers (32, 33) further have central portions surrounded by the peripheral portions (321, 331) and connected to each other at a plurality of sealing areas (36). The lower thin film layer (33) is adapted to contact the heat-producing component (15) at one end, and the heat-dissipating unit (14) at another end. The working liquid (30) is received in the receiving space (35), and is capable of evaporating to absorb the heat produced by the heat-producing component (15), thereby expanding the receiving space (30) and forming protruding facets (34) at the central portions of the upper and lower thin film layers (32, 33) at locations other than the sealing areas (36). The working liquid (30) is capable of condensing when cooled by the heat-dissipating unit (14).

## Description

The invention relates to a heat-conducting device, more particularly to a flexible volume-variable heat-conducting device.

Usually, an electric fan in electronic instruments and equipment, such as computers, or a heat sink with fins for contacting a heat-producing component are used to dissipate heat to ensure normal operation. However, since a motor of the electric fan generates noise, and easily deteriorates after being in use for a period of time, the heat dissipating efficiency is reduced and can cause damage to electrical instruments and equipment. On the other hand, the heat dissipating efficiency when the heat sink is in use requires heat conduction through a relatively long distance and is thus severely hampered by limited space.

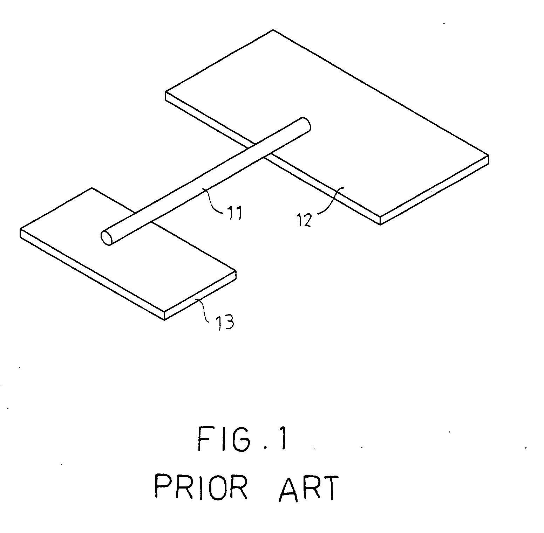

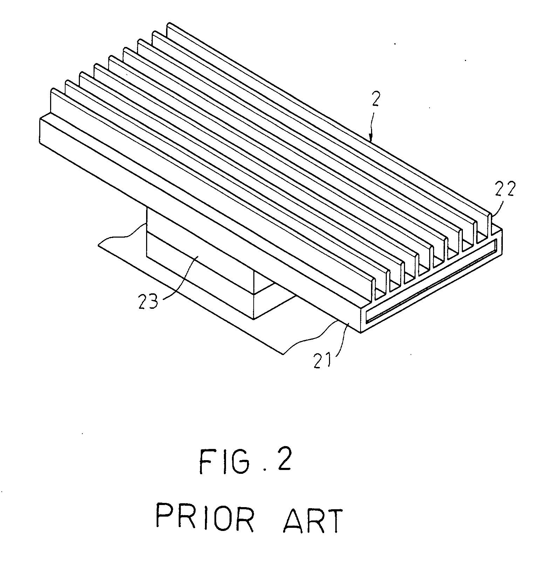

Figure 1 illustrates a conventional heat-conducting pipe 11. The heat-conducting pipe 11 confines a closed space that is filled with an amount of working liquid. The heat-conducting pipe 11 has one end connected to a heat-producing component 13 via a heat-conductive glue, and another end connected to a heat-dissipating plate 12 via a heat-conductive glue. The working liquid is capable of evaporating to absorb heat produced by the heat-producing component 13, and condensing when cooled by the heat-dissipating plate 12. The drawback of the conventional heat-dissipating pipe 11 resides in its relatively large size and relatively small contact area due to the difference between coefficients of expansion of the heat-conducting pipe 11 and the heat-producing component 13, thereby resulting in a decreased heat dissipating efficiency.

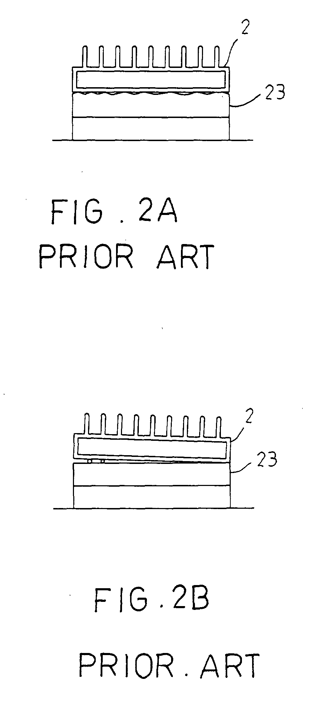

Figure 2 illustrates a conventional heat sink 2. The conventional heat sink 2 has a heat-conductive body 21 formed with a closed space that is filled with a working liquid (not shown). The body 21 has a top surface formed with a plurality of heat-dissipating fins 22, and a bottom surface contacting a heat-producing component 23. It is noted that an improper match between the bottom surface of the body 21 and the heat-producing component 23 due to a processing error, as shown in Figure 2A, and a dot or line contact between the bottom surface of the body 21 and the heat-producing component 23 due to presence of dirt, as shown in Figure 2B, can result in a dramatic decrease in the heat dissipating efficiency.

Therefore, the main object of the present invention is to provide a flexible volume-variable heat-conducting device with an improved heat-conduction effect.

According to the present invention, a flexible volume-variable heat-conducting device is adapted for conducting heat generated by a heat-producing component to a heat-dissipating unit. The heat-conducting device includes flexible upper and lower thin film layers, and an amount of working liquid.

Each of the upper and lower thin film layers is made from a heat-conductive material. The upper and lower thin film layers have peripheral portions that are connected sealingly to each other such that the upper and lower thin film layers cooperatively confine a receiving space therebetween. The upper and lower thin film layers further have central portions surrounded by the peripheral portions and connected to each other at a plurality of sealing areas. The lower thin film layer is adapted to contact the heat-producing component at one end, and the heat-dissipating unit at another end.

The working liquid is received in the receiving space, and is capable of evaporating to absorb the heat produced by the heat-producing component, thereby expanding the receiving space and forming protruding facets at the central portions of the upper and lower thin film layers at locations other than the sealing areas. The working liquid is capable of condensing when cooled by the heat-dissipating unit.

Other features and advantages of the present invention will become apparent in the following detailed description of the preferred embodiments with reference to the accompanying drawings, of which:
Figure 1 is a perspective view of a heat-dissipating device with a conventional heat-conducting pipe;
Figure 2 is a perspective view of another conventional heat-conducting device formed with heat-dissipating fins;
Figure 2A is a fragmentary side schematic view of the conventional heat-conducting device of Figure 2 in a state of use;
Figure 2B is a fragmentary side schematic view of the conventional heat-conducting device of Figure 2 in another state of use;
Figure 3 is a fragmentary perspective view of the first preferred embodiment of a flexible volume-variable heat-conducting device according to this invention;
Figure 4 is a sectional schematic view of the first preferred embodiment;
Figures 5 to 7 are sectional schematic views showing second to fourth preferred embodiments of this invention, respectively;
Figure 8 is a fragmentary perspective view of the fifth preferred embodiment of this invention;
Figure 9 is a sectional schematic view of the fifth preferred embodiment;
Figure 10 is a fragmentary perspective view of the sixth preferred embodiment of this invention;
Figure 10A is an enlarged schematic view showing an encircled portion of Figure 10;
Figure 11 is a sectional schematic view of the sixth preferred embodiment in a state of use; and
Figure 12 is a fragmentary perspective view of the seventh preferred embodiment of this invention.

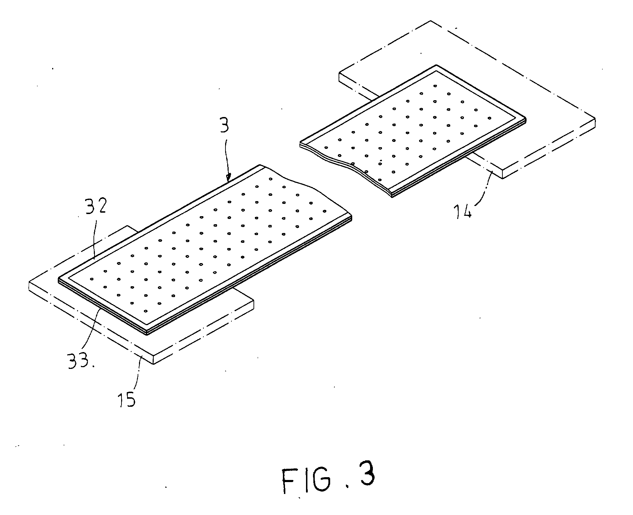

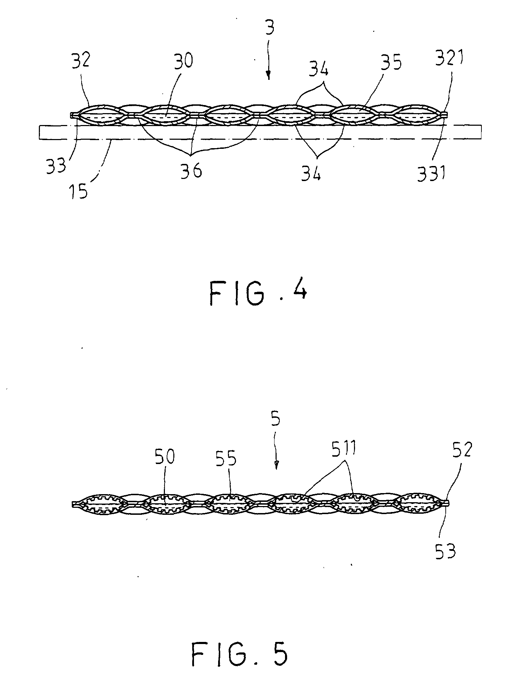

Referring to Figures 3 and 4, according to the first preferred embodiment of this invention, a flexible volume-variable heat-conducting device 3 is shown to be adapted for conducting heat generated by a heat-producing component 15 to a heat-dissipating plate 14, and to include flexible upper and lower thin film layers 32, 33 and an amount of working liquid 30.

Each of the upper and lower thin film layers 32, 33 is made from a heat-conductive material, such as copper or aluminium. The upper and lower thin film layers 32, 33 have peripheral portions 321, 331 that are connected sealingly to each other such that the upper and lower thin film layers 32, 33 cooperatively confine a receiving space 35 therebetween. The upper and lower thin film layers 32, 33 further have central portions surrounded by the peripheral portions 321, 331 and connected to each other at a plurality of sealing areas 36 by spot weldly. The sealing areas 36 thus form an array of sealing spots on the central portions of the upper and lower thin film layers 32, 33 for reinforcing the construction of the heat-conducting device 3. The lower thin film layer 33 is adapted to contact the heat-producing component 15 at one end, and the heat-dissipating plate 14 at another end.

The working liquid, such as water, alcohol, acetone or a refrigerant, is received in the receiving space 35. The working liquid 30 is capable of evaporating to absorb the heat produced by the heat-producing component 15, thereby expanding the receiving space 35 and forming protruding facets 34 at the central portions of the upper and lower thin film layers 32, 33 at locations other than the sealing areas 36. The working liquid 30 is capable of condensing when cooled by the heat-dissipating plate 14.

When the heat-producing component 15 operates at higher temperatures, the air pressure in the receiving space 35 becomes greater so as to increase the areas of the facets 34 that are in contact with the heat-producing component 15 and the heat-dissipating plate 14, thereby resulting in an improvement in the heat-conducting and heat-dissipating efficiencies.

Figure 5 illustrates the second preferred embodiment of a heat-conducting device 5 according to this invention, which is a modification of the first preferred embodiment. Unlike the previous embodiment, each of the upper and lower thin film layers 52, 53 has an inner surface formed with a plurality of thin grooves 511 to permit capillary movement of condensate of the working liquid 50 inside the receiving space 55 in order to enhance the heat-conducting efficiency.

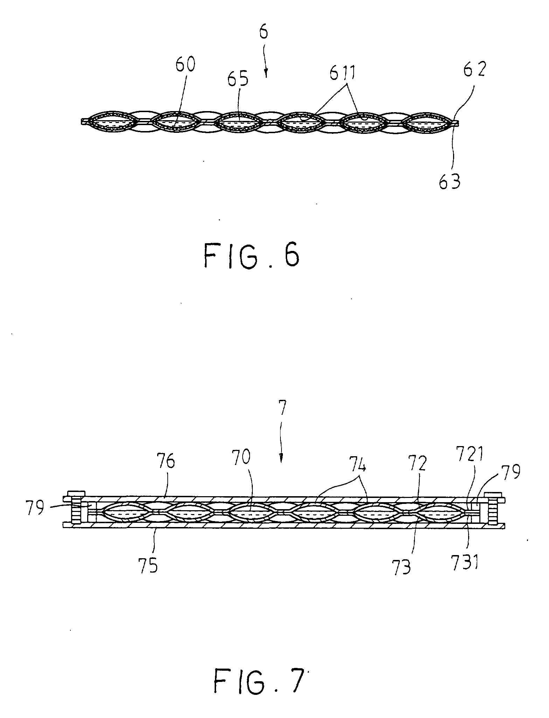

Figure 6 illustrates the third preferred embodiment of a heat-conducting device 6 according to this invention, which is a modification of the first preferred embodiment. Unlike the first preferred embodiment, each of the upper and lower thin film layers 62, 63 has an inner surface provided with a fiber net layer 611 to permit capillary movement of condensate of the working liquid 60 inside the receiving space 65 in order to enhance the heat-conducting efficiency.

Figure 7 illustrates the fourth preferred embodiment of a heat-conducting device 7 according to this invention, which is a modification of the first preferred embodiment. Unlike the first preferred embodiment, the peripheral portions 721, 731 of the upper and lower thin film layers 72, 73 are formed with a plurality of washer receiving holes adapted to permit extension of a plurality of washers 79 therethrough. Thus, when a positioning plate 76 is superimposed on the heat-conducting device 7 and is connected to the heat-producing component 75, the volume-varying capability of the receiving space can be ensured.

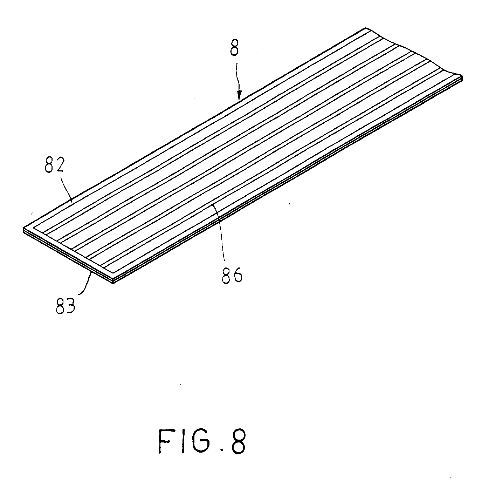

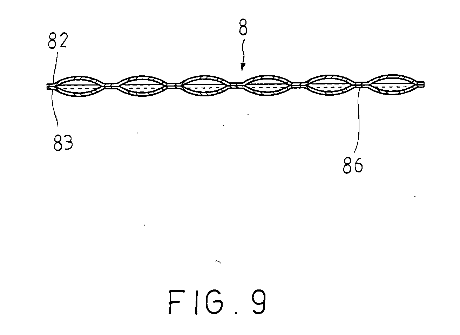

Figures 8 and 9 illustrate the fifth preferred embodiment of a heat-conducting device 8 according to this invention, which is a modification of the first preferred embodiment. Unlike the first preferred embodiment, the sealing areas 86 form parallel sealing strips on the central portions of the upper and lower thin film layers 82, 83.

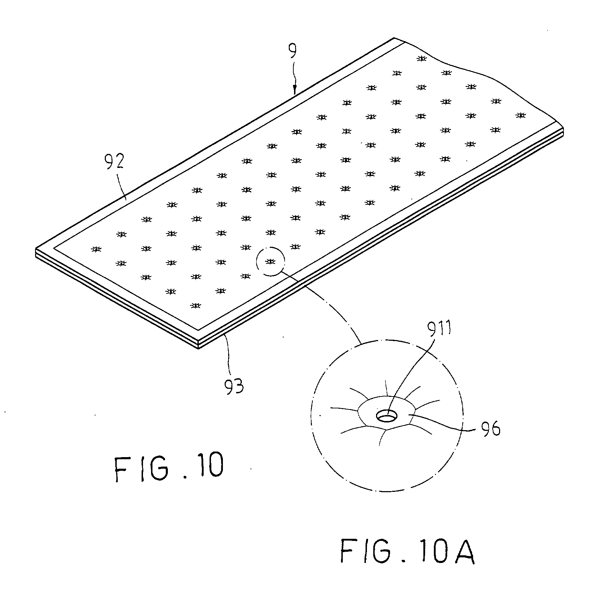

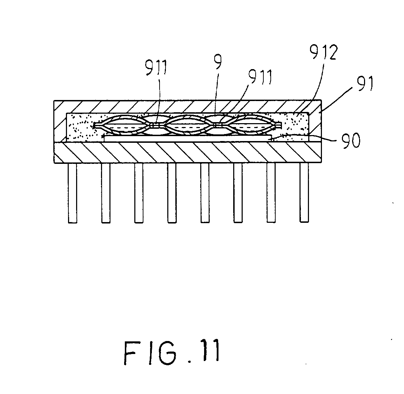

Figure 10 illustrates the sixth preferred embodiment of a heat-conducting device 9 according to this invention, which is a modification of the first preferred embodiment. Unlike the first preferred embodiment, the central portions of the upper and lower thin film layers 92, 93 are formed with an array of aligned holes 911 therethrough. As shown in Figure 10A, each of the sealing areas 96 connects the central portion of the upper and lower thin film layers 92, 93 at peripheries of a respective aligned pair of the holes 911. The heat-conducting device 9 can be disposed in a ceramic casing 91 that is used to package the heat-producing component 90 and that is filled with an amount of filler 912, as shown in Figure 11.

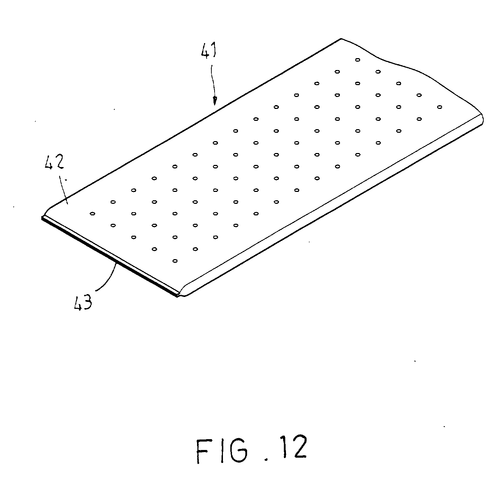

Figure 12 illustrates the seventh preferred embodiment of a heat-conducting device 41 according to this invention, which is a modification of the first preferred embodiment. Unlike the first preferred embodiment, the upper and lower thin film layers 42, 43 are connected integrally so as to acquire a tubular shape.

The following are some of the advantages of the present invention:
1. Due to the facets, when the heat-producing component produces more heat, the contact areas with the lower thin film layer of the heat-conducting device will be increased so as to improve the heat-conducting efficiency.
2. Since the heat-conducting device is formed primary from upper and lower thin film layers that are connected sealingly to each other, fabrication of the heat-conducting device of this invention is easier to conduct than that of the conventional heat-conducting device described beforehand, and the fabrication cost the heat-conducting device of this invention is relatively lower.
3. The upper and lower thin film layers occupy a relatively small amount of space, thereby resulting in increased flexibility during use.

## Claims

1. A flexible volume-variable heat-conducting device (3, 5, 6, 7, 8, 9, 41) for conducting heat generated by a heat-producing component (15, 75, 90) to a heat-dissipating unit (14), said heat-conducting device (3, 5, 6, 7, 8, 9, 41) **characterized by**:
flexible upper and lower thin film layers (32, 52, 62, 72, 82, 92, 42, 33, 53, 63, 73, 83, 93, 43), each of which is made from a heat-conductive material, said upper and lower thin film layers (32, 52, 62, 72, 82, 92, 42, 33, 53, 63, 73, 83, 93, 43) having peripheral portions (321, 331) that are connected sealingly to each other such that said upper and lower thin film layers (32, 52, 62, 72, 82, 92, 42, 33, 53, 63, 73, 83, 93, 43) cooperatively confine a receiving space (35, 55, 65) therebetween, said upper and lower thin film layers (32, 52, 62, 72, 82, 92, 42, 33, 53, 63, 73, 83, 93, 43) further having central portions surrounded by said peripheral portions (35, 55, 65) and connected to each other at a plurality of sealing areas (36), said lower thin film layer (33, 53, 63, 73, 83, 93, 43) being adapted to contact the heat-producing component (15, 75, 90) at one end and the heat-dissipating unit (14) at another end; and
an amount of working liquid (30, 50, 60, 70) received in said receiving space (35, 55, 65), said working liquid (30, 50, 60, 70) being capable of evaporating to absorb the heat produced by the heat-producing component (15, 75, 90), thereby expanding said receiving space (35, 55, 65) and forming protruding facets (34, 74) at said central portions of said upper and lower thin film layers (32, 52, 62, 72, 82, 92, 42, 33, 53, 63, 73, 83, 93, 43) at locations other than said sealing areas (36), said working liquid (30, 50, 60, 70) being capable of condensing when cooled by the heat-dissipating unit (14).

2. The heat-conducting device of Claim 1, **characterized in that** said upper and lower thin film layers (42, 43) are connected integrally to form said receiving space.

3. The heat-conducting device of Claim 1, further **characterized in that** said working liquid (30, 50, 60, 70) is water.

4. The heat-conducting device of Claim 1,further **characterized in that** said working liquid (30, 50, 60, 70) is alcohol.

5. The heat-conducting device of Claim 1, further **characterized in that** said working liquid (30, 50, 60, 70) is acetone.

6. The heat-conducting device of Claim 1, further **characterized in that** said working liquid (30, 50, 60, 70) is a refrigerant.

7. The heat-conducting device of Claim 1, further **characterized in that** each of said upper and lower thin film layers (52, 53) has an inner surface formed with a plurality of thin grooves (511) to permit capillary movement of condensate of said working liquid (50) inside said receiving space (55).

8. The heat-conducting device of Claim 1, further **characterized in that** each of said upper and lower thin film layers (62, 63) has an inner surface provided with a fiber net layer (611) to permit capillary movement of condensate of said working liquid (60) inside said receiving space (65).

9. The heat-conducting device of Claim 1, further **characterized in that** said sealing areas (36) form an array of sealing spots on said central portions of said upper and lower thin film layers (32, 52, 62, 72, 33, 53, 63, 73).

10. The heat-conducting device of Claim 1, further **characterized in that** said sealing areas (86) form parallel sealing strips on said central portions of said upper and lower thin film layers (82, 83).

11. The heat-conducting device of Claim 1, further **characterized in that** said central portions of said upper and lower thin film layers (92, 93) are formed with an array of aligned holes (911) therethrough, each of said sealing areas (96) connecting said central portions of said upper and lower thin film layers (92, 93) at peripheries of a respective aligned pair of said holes (911).

12. The heat-conducting device of Claim 1, further **characterized in that** said peripheral portions (721, 731) of said upper and lower thin film layers (72, 73) are formed with a plurality of washer receiving holes adapted to permit extension of a plurality of washers (79) therethrough.
